# EUROPEAN PATENT APPLICATION

(11) **EP 4 227 097 A2**
(43) Date of publication of application: **16.08.2023**
(21) Application number: 23155845.3
(22) Date of filing: 09.02.2023
(51) Int. Cl.: B33Y 80/00, H01H 13/70, H05K 1/14

(54) **3D PRINTED ATTACHMENT DEVICES FOR ELECTRONICS**

(30) Priority: 11.02.2022 US 202263309295 P; 03.02.2023 US 202318105454
(71) Applicant: Accenture Global Solutions Limited, Dublin 4 (IE)
(72) Inventor: GREENSPAN, Mark Benjamin, San Francisco, 94110 (US); TABB, Taylor, San Francisco, 94105 (US); PACIK-NELSON, Noah Gideon, Boston, 02114 (US); GALLO, Eric Michael, Moretown, 05660 (US); DANIELESCU, Lavinia Andreea, San Francisco, 94110 (US)
(74) Representative: Swindell & Pearson Limited

(57) **Abstract**

Electrical input devices, conductive traces, and microcontroller interface devices can be created in a single print using a multi-material 3D printing process. The devices can include a non-conductive material portion and a conductive material portion. The non-conductive and conductive material portions are integrally formed during a single 3D printing process. For example, a fully functional QWERTY keyboard, ready to receive a microcontroller, can be multi-material 3D printed using the techniques described herein.

## Description

### CROSS-REFERENCE TO RELATED APPLICATIONS

This application claims the benefit of U.S. Provisional Application Serial No. 63/309,295 filed February 11, 2022. The disclosure of the prior application is considered part of (and is incorporated by reference in) the disclosure of this application.

### TECHNICAL FIELD

This disclosure generally relates to 3D printed electronics interface devices, 3D printed resistors, and 3D printed passive or active electronic components.

### BACKGROUND

Components for human-computer interaction devices such as keyboards, AAC ("augmentative and alternative communication") devices, video game controllers and the like require power and connection to processing either through a wired or wireless connection. Current designs for such connections involve an array of clips, sockets, soldering, etc. to make complete operational devices.

3D printing provides an ideal alternative to traditional manufacturing for production of low volume, complex structures, but to date, has primarily been utilized for prototyping static parts. Recent advances in 3D printing have provided tools for simpler customization, but no existing 3D printing process allows for the production of complete custom electronics (e.g., including interfaces for microcontrollers, microprocessors, electronics boards, etc.) in a single 3D print run.

### SUMMARY

In general, the subject matter described in this specification relates to the use of multi-material 3D printing (additive manufacturing) to produce durable and simple electronic attachment and interfacing to electronics, processing, and power. In some embodiments, the methods described herein enable the incorporation of sockets and attachment devices similar to those used in non-3D printed electronics systems to create the necessary interconnects to route signals from 3D printed sensors, inputs, etc. to microcontrollers, processors, signal interfaces, power supplies and other electrical components not included in the 3D printed devices. These items can include both mechanical and electrical systems, and the ability to be deformed or deflected during use. In some embodiments, such sockets and attachment devices can be 3D printed in a single 3D printing process run using multi-material 3D printing processes.

Some aspects described herein include using multi-material 3D printing to produce devices that include electrical and/or deformable components and an integrated connection to electrical components such as processing, power, communication, etc. Such components can be created in a single print on a multi-material 3D printer, requiring no assembly. In many instances, these devices require no support material, producing a functional device the moment a print finishes. Designs such as, but not limited to, fully functional customized keyboards, gamepads, and many other electromechanical devices can be created using the techniques described herein that simplify manufacturing, reduce/eliminate the need for secondary operations, reduce the number of components, lower overall cost, and the like.

The details of one or more implementations are set forth in the accompanying drawings and the description, below. Other potential features and advantages of the disclosure will be apparent from the description and drawings, and from the claims.

### BRIEF DESCRIPTION OF THE DRAWINGS

FIG. 1 illustrates an example multi-material 3D printed circuit board that includes a pull up resistor and a socket interface for receiving a microcontroller in accordance with some embodiments.
FIG. 2 illustrates another example technique for interfacing a multi-material 3D printed circuit board with a microcontroller.
FIG. 3 illustrates another example technique for interfacing a multi-material 3D printed circuit board with a microcontroller.
FIG. 4 illustrates another example technique for interfacing a multi-material 3D printed circuit board with a microcontroller.
FIG. 5 illustrates another example technique for interfacing a multi-material 3D printed circuit board with a microcontroller.
FIG. 6 illustrates another example technique for interfacing a multi-material 3D printed circuit board with a microcontroller.
FIG. 7 illustrates another example technique for interfacing a multi-material 3D printed circuit board with a microcontroller.
FIG. 8 illustrates another example multi-material 3D printed circuit board that includes three keys and corresponding conductive traces of specific lengths.
FIG. 9 is a graph showing the voltage outputs resulting from depressing the keys of the multi-material 3D printed circuit board of FIG. 8.
FIG. 10 illustrates another type of circuit board and a multi-material 3D printed header or socket in accordance with some embodiments.
FIG. 11 illustrates an example configuration of an interface between a circuit board pin and a multi-material 3D printed header or socket.
FIG. 12 illustrates another example configuration of an interface between a circuit board pin and a multi-material 3D printed header or socket.
FIG. 13 illustrates another example configuration of an interface between a circuit board pin and a multi-material 3D printed header or socket.
FIG. 14 illustrates another example configuration of an interface between a circuit board pin and a multi-material 3D printed header or socket.
FIG. 15 illustrates an example multi-material 3D printed input device in accordance with some embodiments.
FIGs. 16A-16C illustrate another example multi-material 3D printed input device in accordance with some embodiments.
FIG. 17 illustrates an example multi-material 3D printed keyboard device in accordance with some embodiments.
FIG. 18 schematically illustrates an example AAC device that can be fully constructed using the multi-material 3D printing concepts described herein.
FIG. 19 illustrates an example prosthetic device that can be fully constructed using the multi-material 3D printing concepts described herein.
FIG. 20 schematically illustrates another example device that can be fully constructed using the multi-material 3D printing concepts described herein.
FIG. 21 is a schematic diagram that shows an example of a computing device and a mobile computing device.

Like reference symbols in the various drawings indicate like elements.

### DETAILED DESCRIPTION

As described herein, multi-material 3D printing (additive manufacturing) can be used to produce durable and simple electronic attachment devices that can be used to interface to electronics, processing, power, and the like. Moreover, 3D printed electronics (such as traces, resistors, inductors, capacitors and filters, etc.) can be created by mixing carbon, copper, graphene, or other conductive materials with traditional printable materials to create conductive composite filaments/devices. A 3D printed electronic attachment method enables rapid integration of these 3D printed parts with larger scale systems by facilitating direct connection from 3D printed electronics and non-3D printed components. Accordingly, this disclosure describes multiple types of 3D printed electronics interface components. The 3D printed electronics interface components described herein can be used to greatly reduce the number of manufacturing steps (e.g., assembly steps) to create complete electro-mechanical devices. In some embodiments, 3D printed multi-material versions of input devices like switches can also be created by the 3D printing process (thus moving them from being a separate component requiring wiring and assembly to be part of the monolithic object). Alternatively, input devices can be integrated using 3D printed electronics interfaces described herein that create a pre-wired and robust electrical connection interface to non-printed electrical hardware (e.g., PCBs, SOMs, or to the ICs themselves, etc.). This reduces the number manufacturing steps and largely eliminates the need for secondary operations and assembly.

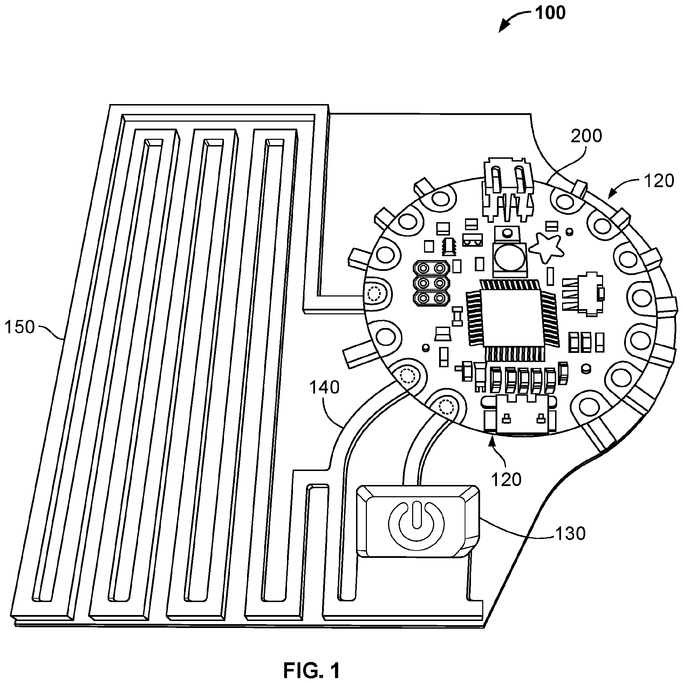

Referring to FIG. 1, to reduce the complexity of the process of creating a fully functional electro-mechanical devices, the inventors designed and verified an example 3D printed a circuit board 100 that includes a socket 120 for direct integration with an example microcontroller 200 (which is representative of any type of printed circuit board and/or other types of electronics). This particular example circuit board 100 was designed for integration with a microcontroller 200 that has large through-hole connectors around the outer periphery of the microcontroller 200. The socket 120 includes 3D printed conical electrodes on which the through-hole connectors of the microcontroller 200 are placed. In some embodiments, a small amount of conductive paint is applied to create secure electrical connections between the 3D printed conical electrodes of the socket 120 and the through-hole connectors of the microcontroller 200.

In some embodiments, secure electrical and physical connections can be created by applying heat to the 3D printed conical electrodes of the socket 120, and then press-fitting the microcontroller 200 into engagement with the circuit board 100 (rather than using the conductive paint). In some other embodiments, various types of mechanical latches (e.g., reversible, snap-together components) can be 3D printed to create the secure physical attachment between the microcontroller 200 and the circuit board 100.

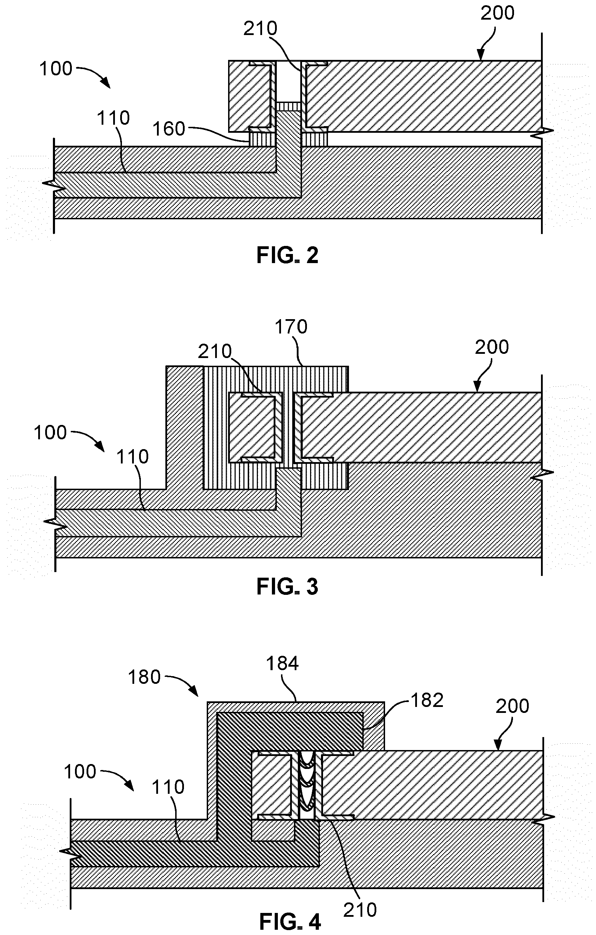

While the depicted example circuit board 100 uses the 3D printed conical electrodes to interface electrically with the through-hole connectors of the circuit board 100, other types of electrical interfaces between the 3D printed circuit board 100 and the microcontroller 200 are also envisioned. For example, FIG. 2 illustrates the use of an adhesive 160 (e.g., a conductive epoxy, a conductive RTV silicone, and the like) in the form of a pad that is used to physically and conductively couple a via 210 ("vertical interconnect access"), a plated-through hole of the microcontroller 200, to a conductive member 110 of the 3D printed circuit board 100. In this example, the conductive member 110 is 3D printed so that it projects/extends from a surface of the 3D printed circuit board 100. As shown, in some embodiments the projection of the conductive member 110 can extend into the via 210 of the microcontroller 200.

In another example depicted in FIG. 3, an adhesive 170 (e.g., a conductive epoxy, a conductive RTV silicone, and the like) in the form of a cast or molded member 170 is used to physically and conductively couple the microcontroller 200 (which can include the via 210) to the 3D printed circuit board 100 with its conductive member 110.

FIG. 4 illustrates another technique for attaching, physically and electrically, the microcontroller 200 to the 3D printed circuit board 100. This technique can be referred to as a print-in-place technique. In this example, the microcontroller 200 is placed on the base circuit board 100, and then another circuit board portion 180 is 3D printed over the microcontroller 200 to create the physical and electrical attachment between the microcontroller 200 and the 3D printed circuit board 100. The 3D printed circuit board portion 180 includes an inner conductive portion 182 (in electrical connection with the conductive member 110 of the 3D printed circuit board 100) and an outer nonconductive portion 184.

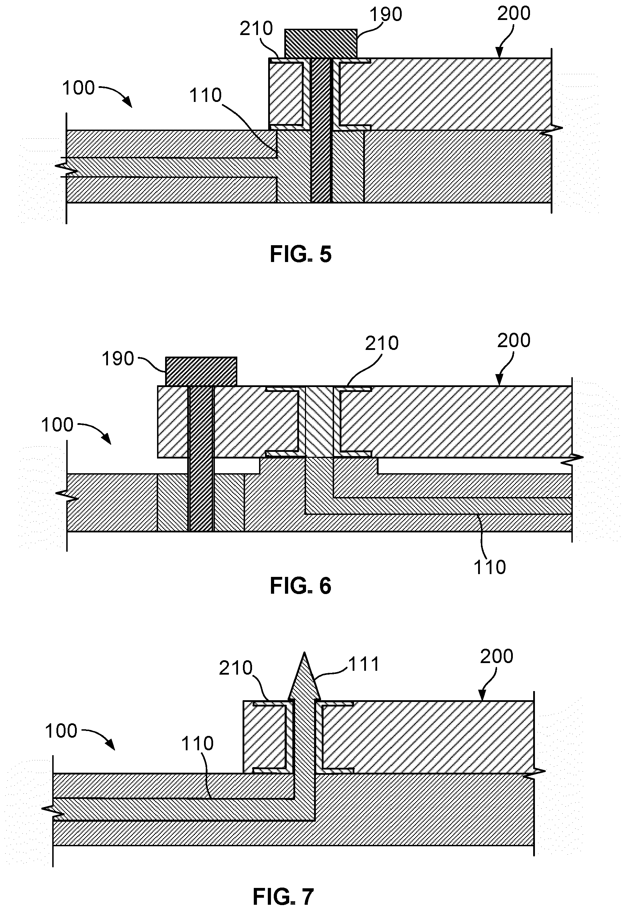

FIGs. 5 and 6 illustrate two additional mechanical attachment techniques using a screw 190. In particular, FIG. 5 illustrates a "through-pad" attachment technique (using in-line vias 110 and 210), and FIG. 6 illustrates a "through-hole" attachment technique that provides pad-to-pad electrical connection that is spaced apart from the location of the screw 190. In these examples, the 3D printed circuit board 100 includes a threaded hole with which the screw 190 is releasably engageable. In some embodiments, the threaded hole is 3D printed.

FIG. 7 illustrates another technique for attaching, physically and electrically, the microcontroller 200 to the 3D printed circuit board 100. In this example, the conductive member 110 of the 3D printed circuit board 100 includes a 3D printed projection with a 3D printed deformable head 111 at the free end of the conductive member 110. This 3D printed deformable head 111 provides the equivalent of a snap closure onto which the microcontroller 200 (e.g., using the via 210) would be pressed to mechanically and electrically connect the microcontroller 200 to the circuit board 100. In some embodiments, such a snap closer can comprise a plastic rivet clip or push fastener (e.g., of the type that is used for a car or a wall anchor type of design). As shown, such a snap closer provided by the conductive member 110 with the 3D printed deformable head 111 could be printed to extend out of the circuit board 100. The microcontroller 200 can be snapped on top so that the conductive member 110 is within the via 210, and the head 111 is expanded on the other side of the via 210 to couple and retain the microcontroller 200 to the 3D printed circuit board 100. As shown, the 3D printed deformable head 111 can comprise a barbed shape in some embodiments.

Still referring to FIG. 1, the circuit board 100 also includes multiple 3D printed electronic traces 140. In this example, all of the electronic traces 140 were printed with a cross-section of 2.54 mm x 2.54 mm. At that cross-sectional area, the electronic traces 140 have a measured resistance of approximately 200 ohm(Q)/cm. With the resistance per centimeter (in length) being known, the electronic traces 140 can be 3D printed with particular lengths to attain desired resistances. For example, this value was used for 3D printing the 10 kΩ resistor 150 (created from a 50 cm trace length) that is used as a pull down resistor in FIG. 1.

The example 3D printed circuit board 100 includes conductive portions and non-conductive portions (both of which, in some embodiments, can be 3D printed in a single run using a multi-material 3D printing process). Moreover, the example 3D printed circuit board 100 includes an example input device 130. Such an input device 130 is depicted here as a key or switch that can be depressed by a user to create a digital or analog input to the microcontroller 200.

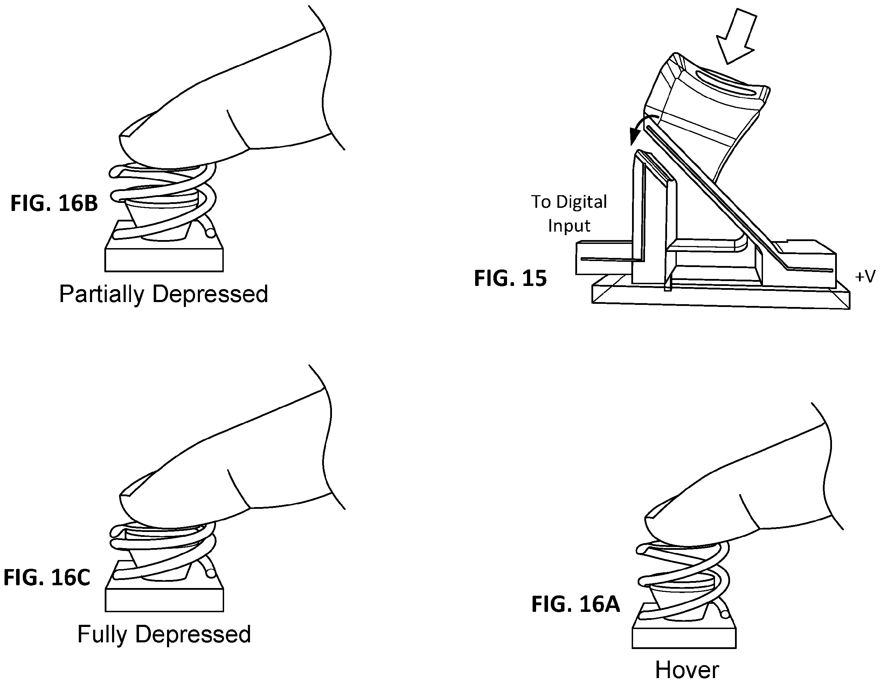

Referring also to FIGs. 15 and 16A-C, there are at least two types of input devices depicted that can be created using the multi-material 3D printing techniques described herein and implemented with the 3D printed electronic circuit boards and interface devices described herein. These are deformable key-type inputs, though other input styles (e.g., sliders, knobs, or dials, etc.) can also be designed created using this same method.

FIG. 15 depicts a digital (binary) input key that is 3D printed with two types of materials: (i) a conductive material comprising a cantilever spring that deforms under the application of force and (ii) a non-conductive material comprising the keycap and base.

FIGs. 16A-C depict example analog (continuously varying signal) keys that include two types of materials: (i) a non-conductive material part comprising a base, a coil spring, and a keycap, and (ii) a conductive material part comprising a flat circular electrode and lead. The flat circular electrode extends to bottom of the key and is read by a capacitance breakout board and attached to a microcontroller. Key deformation is detected when a user's finger compresses the spring and moves closer to the electrode beneath it, acting as a parallel capacitor.

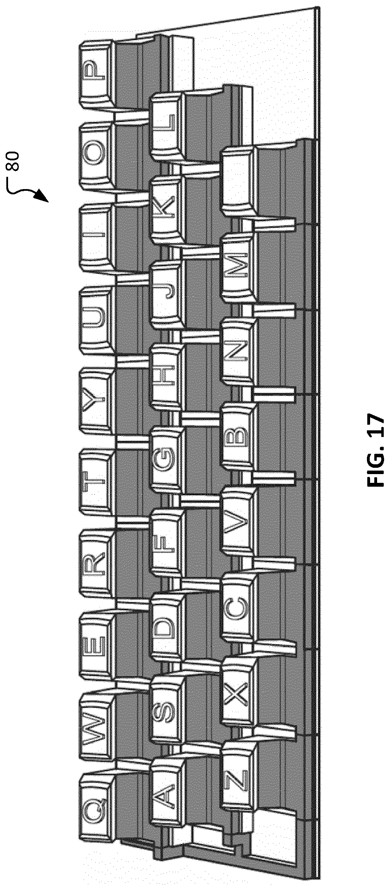

FIG. 17 depicts an example customized QWERTY keyboard 80 that was made by multi-material 3D printing. An individual non-conductive part file was then created for each key, where each individual keycap had a custom letter of the alphabet texture, plus a 'space' key, for a total of 27 inputs. Each key's complementary conductive and non-conductive components were saved, resulting in 27 non-conductive and 27 conductive part files, though all conductive part files were identical.

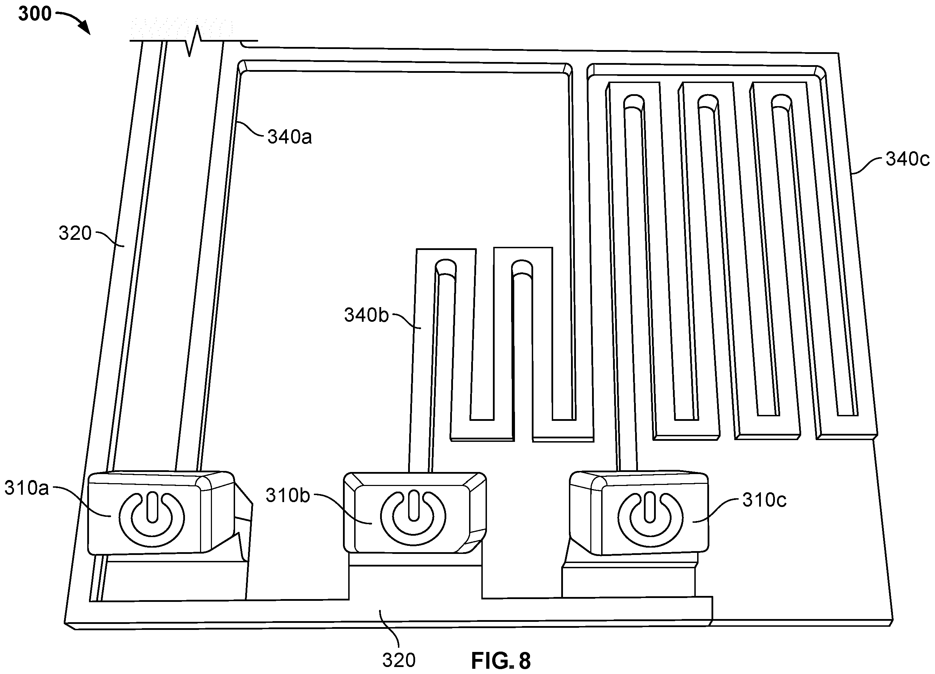

Referring now to FIG. 8, another example 3D printed circuit board 300 includes a first key 310a, a second key 310b, and a third key 310c. The keys 310a-c were multi-material 3D printed in accordance with the concepts described herein. The circuit board 300 also includes multiple 3D printed electronic traces. For example, the circuit board 300 includes an input trace 320 that can be used to electrically connect each of the keys 310a-c to a voltage source. In addition, each of the keys 310a-c has a corresponding output trace. In particular, the first key 310a has a first output trace 340a, the second key 310b has a second output trace 340b, and the third key 310c has a third output trace 340c. When an individual key is depressed, its circuit is closed, and the corresponding output trace is energized by the voltage source via the input trace 320. Each of the output traces 340a-c can be connected to analog input (e.g., of a microcontroller or other type of circuitry) that can detect the voltage at the input.

The output traces 340a-c each have a unique length in comparison to each other. In this example, the first output trace 340a is a short trace, the second output trace 340b is a medium trace, and the third output trace 340c is a long trace. The voltage drop resulting from current flowing through the trace 340a-c depends on the length of the trace 340a-c (as a function of the resistance of the trace 340a-c). Accordingly, the voltage measured at the end of the output traces 340a-c (e.g., at the input), will correspond to the length of the particular output trace 340a-c that is energized (by the depressing of the keys 310a-c). Utilizing this technique, multiple digital keys can be read by a single analog input by varying the trace length from each key to the microcontroller.

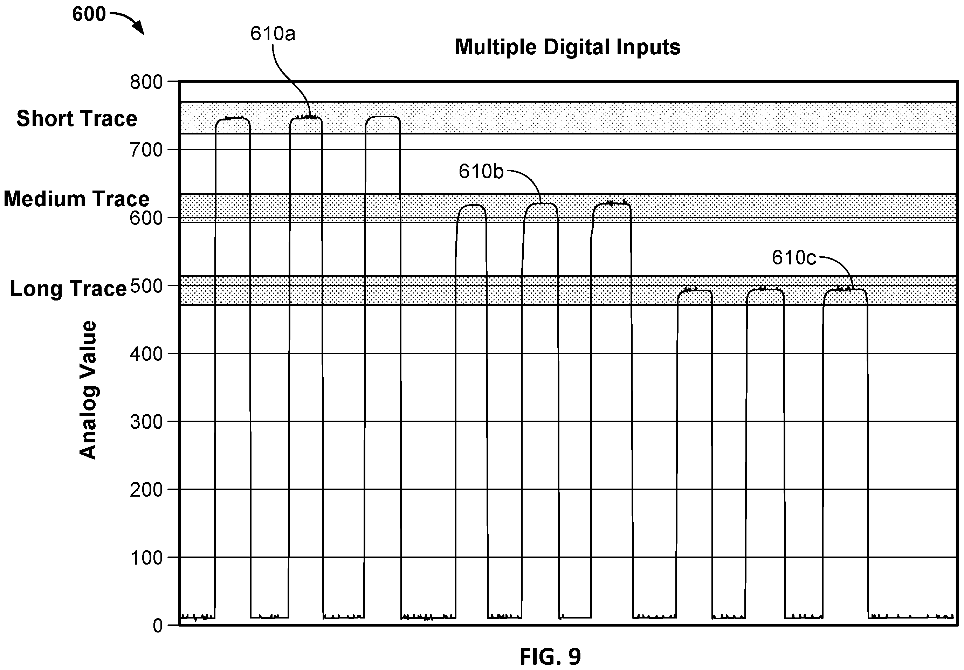

Referring also to FIG. 9, a graph 600 shows three input signals (voltages) from individually depressing each of the three keys 310a-c. The first three input signals 610a are the resulting voltage input from three instances of depressing the first key 310a that has the short first output trace 340a. The second three input signals 610b are the resulting voltage input from three instances of depressing the second key 310b that has the medium second output trace 340b. In addition, the third three input signals 610c are the resulting voltage input from three instances of depressing the third key 310c that has the long third output trace 340c.

As described above, devices such as, but not limited to, a fully functional QWERTY keyboard and a 3D printed circuit board that includes a socket that is ready to receive and interface with a microcontroller, can be multi-material 3D printed using the techniques described herein.

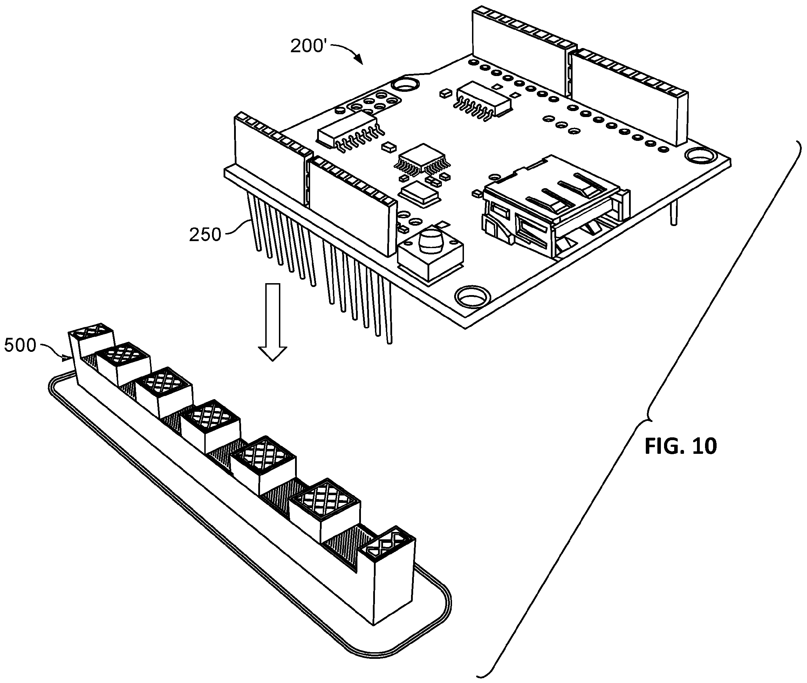

Referring to FIG. 10, some circuit boards (such as the circuit board 200' illustrated) are configured to interface electrically with other devices using pins 250 that extend from the circuit board 200'. In such a case, a header or socket 500 can be 3D printed to provide the electrical interface (i.e., to receive the pins 250). In some embodiments, the mechanical structure of the receiving 3D printed socket 500 is fabricated without a top layer and using an open infill pattern. Such a 3D printed structure can allow the pins 250 to penetrate the surface and make electrical connection with 3D conductive material within the socket 500.

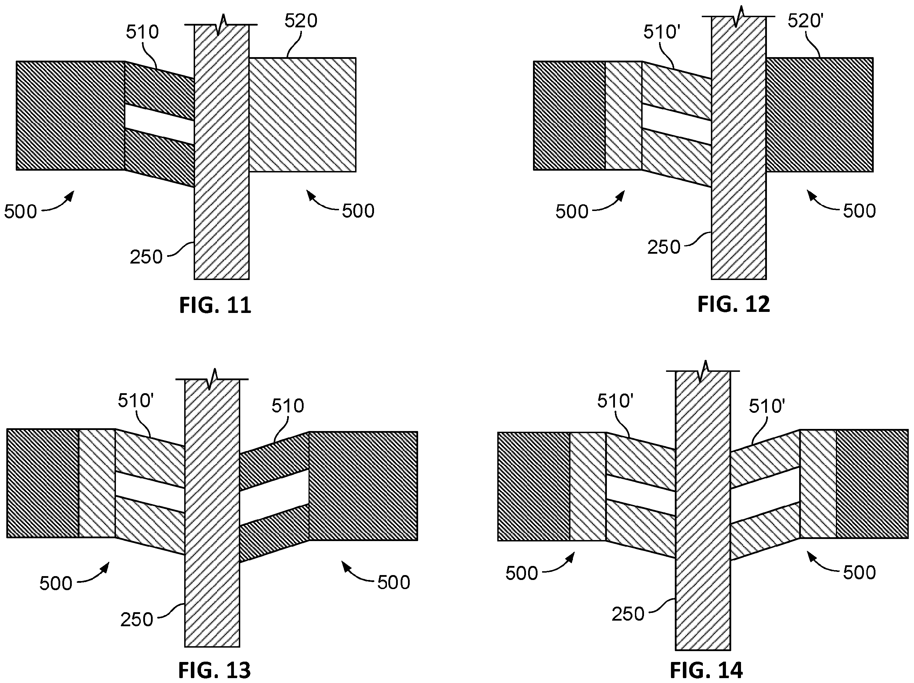

Referring also to FIGs. 11-14, various types of 3D printed sockets 500 can be multi-material 3D printed in configurations to receive the pins 250 of a circuit board. In the configuration of FIG. 11, the 3D printed socket includes a flexible and deformable non-conductive resilient member 510 that elastically deforms as the pin 250 is being inserted and subsequently presses the pin 250 against a conductive rigid member 520 (that is non-deformable). In the configuration of FIG. 12, the resilient member 510' (deformable) is conductive and the rigid member 520' (non-deformable) is non-conductive. In the configuration of FIG. 13, the pin 250 is held between a conductive resilient member 510' (deformable) and a non-conductive resilient member 510 (non-deformable). In the configuration of FIG. 14, the pin 250 is held between two of the conductive resilient members 510' (deformable). Any of these configurations, and combinations of these configurations, can be used to multi-material 3D print sockets 500 that electrically interface with circuit boards (such as the circuit board 200') that include one or more pins 250. In some embodiments, the resilient member 510 can be configured as a deformable arch, pad, and the like, rather than the fingers or pillars as depicted.

The inventive concepts of this disclosure can be implemented in many other contexts in addition to those described above. For example, the multi-material 3D printing techniques (using conductive and non-conductive materials) and deflectable designs can be used to efficiently create devices such as, but not limited to, battery holders, electrical connectors, switches, sensors, and so on. In addition, the inventive concepts of this disclosure can be implemented in many devices. FIGs. 17-19 provide some non-limiting examples of the kinds of devices that can be constructed using the inventive multi-material 3D printing techniques (using conductive and non-conductive materials) and/or deflectable designs as described herein.

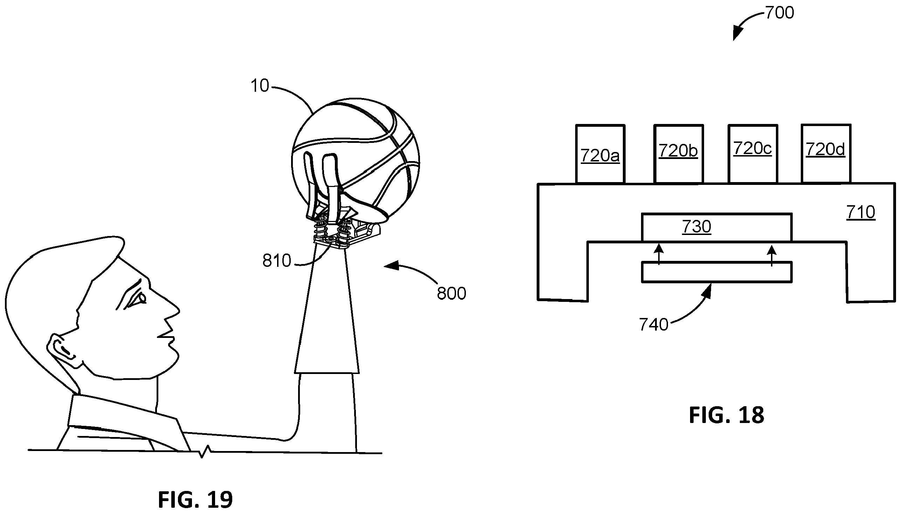

FIG. 18 schematically illustrates an example AAC ("augmentative and alternative communication") device 700 that can be fully constructed using the multi-material 3D printing concepts described herein. The AAC device 700 includes a base or housing 710, multiple input/output devices 720a-d, a socket or interface device 730, and one or more electronic assemblies such as the depicted microcontroller board 740. As depicted, the 3D printed interface device 730 can be configured so that the microcontroller board 740 can be readily attached to become integrated with the AAC device 700. In some embodiments, the microcontroller board 740 can be snapped-in, or otherwise readily attached. This method provides a simple attachment to enable functionality such as directly receiving input signals, providing power either through an attached battery or external connection, providing connection to external processing such as a computer through USB or similar connections, and so on. In some embodiments, the microcontroller board 740 has points that directly couple to 3D printed electronic traces of the AAC device 700, is readily removable, and/or requires essentially no additional steps for connection.

FIG. 19 illustrates an example prosthetic device 800 that can be fully constructed using the multi-material 3D printing concepts described herein. In this example, the prosthetic device 800 is configured for handling a basketball 10 and includes multiple deflectable elements. The prosthetic device 800 can be 3D printed and can include a 3D printed socket 810 that is configured to receive one or more electronics devices including, but not limited to a microcontroller board. Accordingly, the multi-material 3D printing techniques described herein can facilitate the efficient construction of a sophisticated device such as the prosthetic device 800 that can include integrated electronics for sensing, feedback, decision assistance, maintenance, and the like.

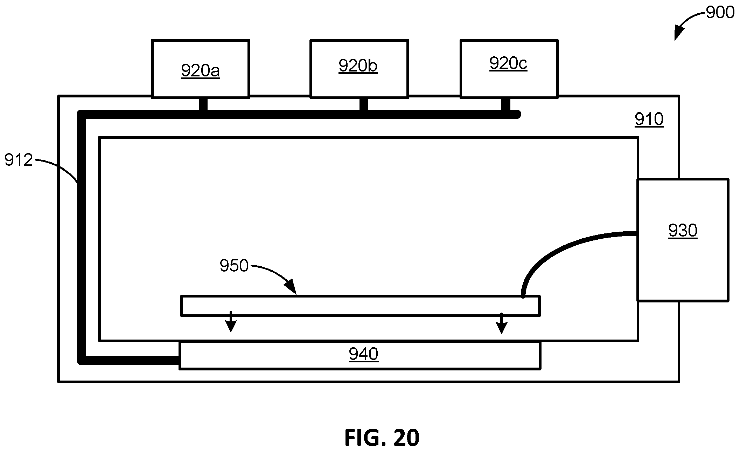

FIG. 20 schematically illustrates another example device 900 that can be fully constructed using the multi-material 3D printing concepts described herein. The device 900 illustrates a generic device that includes a 3D printed housing 910 with embedded 3D printed electronics interconnections 912 (conductive traces). The device 900 includes one or more input devices 920a-c (e.g., buttons, keys, or other types of switches), one or more sensors 930, and a 3D printed interface device 940 can be configured so that the microcontroller board 950 (or other types of electronics) can be readily attached to become integrated with the device 900.

The device 900 illustrates that 3D printed housings for electronics, including processing boards, sensors, peripherals, communications and other electrical components can be printed to directly connect to components to avoid the need for internal wiring (soldering, wrapping, other manual connection types). 3D printed housings (e.g., the housing 910) can include the complete wiring for an multicomponent integrated system, allowing each component to be snapped into the housing instead of manually wired.

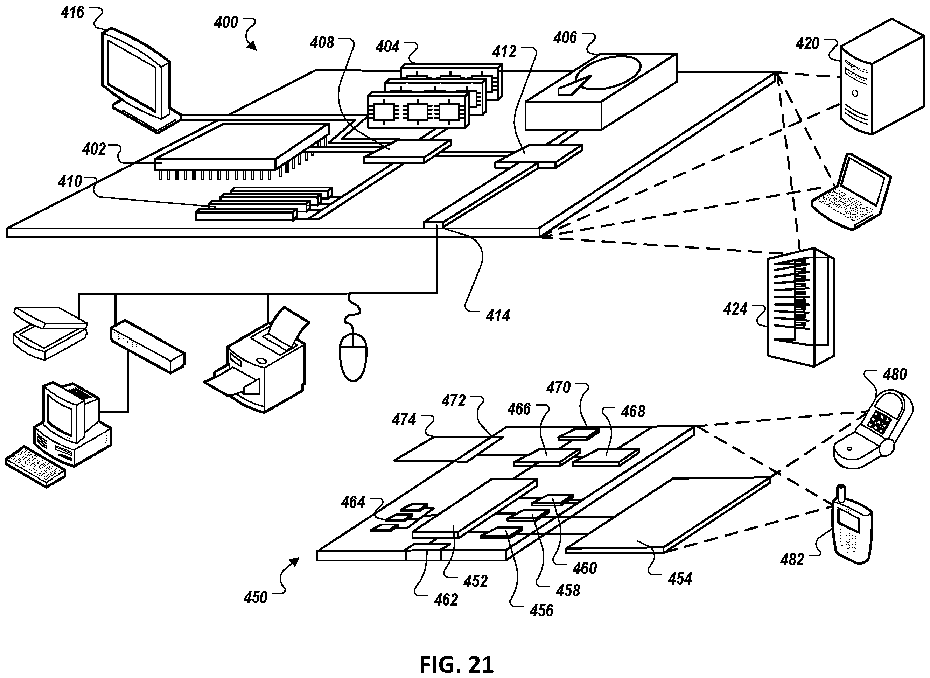

FIG. 21 shows an example of a computing device 400 and an example of a mobile computing device that can be used to implement the techniques described here. The computing device 400 is intended to represent various forms of digital computers, such as laptops, desktops, workstations, personal digital assistants, servers, blade servers, mainframes, and other appropriate computers. The mobile computing device is intended to represent various forms of mobile devices, such as personal digital assistants, cellular telephones, smart-phones, and other similar computing devices. The components shown here, their connections and relationships, and their functions, are meant to be exemplary only, and are not meant to limit implementations of the inventions described and/or claimed in this document.

The computing device 400 includes a processor 402, a memory 404, a storage device 406, a high-speed interface 408 connecting to the memory 404 and multiple high-speed expansion ports 410, and a low-speed interface 412 connecting to a low-speed expansion port 414 and the storage device 406. Each of the processor 402, the memory 404, the storage device 406, the high-speed interface 408, the high-speed expansion ports 410, and the low-speed interface 412, are interconnected using various busses, and can be mounted on a common motherboard or in other manners as appropriate. The processor 402 can process instructions for execution within the computing device 400, including instructions stored in the memory 404 or on the storage device 406 to display graphical information for a GUI on an external input/output device, such as a display 416 coupled to the high-speed interface 408. In other implementations, multiple processors and/or multiple buses can be used, as appropriate, along with multiple memories and types of memory. Also, multiple computing devices can be connected, with each device providing portions of the necessary operations (e.g., as a server bank, a group of blade servers, or a multiprocessor system).

The memory 404 stores information within the computing device 400. In some implementations, the memory 404 is a volatile memory unit or units. In some implementations, the memory 404 is a non-volatile memory unit or units. The memory 404 can also be another form of computer-readable medium, such as a magnetic or optical disk.

The storage device 406 is capable of providing mass storage for the computing device 400. In some implementations, the storage device 406 can be or contain a computer-readable medium, such as a floppy disk device, a hard disk device, an optical disk device, or a tape device, a flash memory or other similar solid state memory device, or an array of devices, including devices in a storage area network or other configurations. A computer program product can be tangibly embodied in an information carrier. The computer program product can also contain instructions that, when executed, perform one or more methods, such as those described above. The computer program product can also be tangibly embodied in a computer- or machine-readable medium, such as the memory 404, the storage device 406, or memory on the processor 402.

The high-speed interface 408 manages bandwidth-intensive operations for the computing device 400, while the low-speed interface 412 manages lower bandwidth-intensive operations. Such allocation of functions is exemplary only. In some implementations, the high-speed interface 408 is coupled to the memory 404, the display 416 (e.g., through a graphics processor or accelerator), and to the high-speed expansion ports 410, which can accept various expansion cards (not shown). In the implementation, the low-speed interface 412 is coupled to the storage device 406 and the low-speed expansion port 414. The low-speed expansion port 414, which can include various communication ports (e.g., USB, Bluetooth, Ethernet, wireless Ethernet) can be coupled to one or more input/output devices, such as a keyboard, a pointing device, a scanner, or a networking device such as a switch or router, e.g., through a network adapter.

While this specification contains many specific implementation details, these should not be construed as limitations on the scope of any invention or of what may be claimed, but rather as descriptions of features that may be specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described herein as acting in certain combinations and even initially claimed as such, one or more features from a claimed combination can in some cases be excised from the combination, and the claimed combination may be directed to a subcombination or variation of a subcombination.

Particular embodiments of the subject matter have been described. Other embodiments are within the scope of the following claims. For example, the actions recited in the claims can be performed in a different order and still achieve desirable results. As one example, the processes depicted in the accompanying figures do not necessarily require the particular order shown, or sequential order, to achieve desirable results.

## Claims

1. A multi-material 3D printed circuit board comprising:
non-conductive material portions; and
conductive material portions comprising an interface configured to couple, physically and conductively, with a microcontroller or electronics board.

2. The 3D printed circuit board of claim 1, wherein the interface comprises a socket comprising a plurality of conical electrodes configured to couple, physically and electrically, with through-holes of the microcontroller or electronics board.

3. The 3D printed circuit board of claim 1 or 2, wherein the interface comprises a header or socket configured to couple, physically and electrically, with pins of the microcontroller or electronics board.

4. The 3D printed circuit board of claim 1, 2 or 3, wherein the interface comprises a 3D printed projection configured to extend into a via of the microcontroller or electronics board.

5. The 3D printed circuit board of any of the preceding claims, wherein the interface comprises a 3D printed projection configured to couple with the microcontroller or electronics board using an adhesive.

6. The 3D printed circuit board of any of the preceding claims, wherein the interface comprises a 3D printed threaded hole configured to receive a screw to couple the 3D printed circuit board with the microcontroller or electronics board.

7. The 3D printed circuit board of any of the preceding claims, wherein the interface comprises a 3D printed projection configured to extend through a via of the microcontroller or electronics board, and wherein the 3D printed projection includes a 3D printed deformable head configured to expand on an opposite side of the microcontroller or electronics board to retain the microcontroller or electronics board to the 3D printed circuit board.

8. The 3D printed circuit board of any of the preceding claims, further comprising:
one or more electrical input devices, each electrical input device comprising:
a non-conductive material portion; and
a conductive material portion, wherein the non-conductive and conductive material portions are integrally formed using a multi-material 3D printing process, and wherein deformation of the electrical input device causes an electrical variance through the conductive material portion that is responsive to the deformation.

9. The 3D printed circuit board of claim 8, wherein the one or more electrical input devices further comprises a 3D printed input trace made of the conductive material.

10. The 3D printed circuit board of claim 8 or 9, wherein the one or more electrical input devices further comprises a plurality of 3D printed input traces made of the conductive material, and wherein each 3D printed input trace of the plurality of 3D printed input traces has a different length and resistance.

11. A method of manufacturing an electrical interface, the method comprising:
using a single run of a multi-material 3D printing process to create a multi-material 3D printed circuit board comprising: (i) non-conductive material portions; and (ii) conductive material portions comprising an interface configured to couple, physically and conductively, with a microcontroller or electronics board.

12. The method of claim 11, wherein the interface comprises deformable portions and non-deformable portions.

13. The method of claim 11 or 12, wherein the interface comprises a socket comprising a plurality of conical electrodes configured to couple, physically and electrically, with through-holes of the microcontroller or electronics board.

14. The method of claim 11, 12 or 13, wherein the interface comprises a header or socket configured to couple, physically and electrically, with pins of the microcontroller or electronics board.

15. The method of any of claims 11 to 14, wherein the interface comprises at least one of:
a 3D printed projection configured to extend into a via of the microcontroller or electronics board;
a 3D printed projection configured to couple with the microcontroller or electronics board using an adhesive.
a 3D printed threaded hole configured to receive a screw to couple the 3D printed circuit board with the microcontroller or electronics board; or
a 3D printed projection configured to extend through a via of the microcontroller or electronics board, and wherein the 3D printed projection includes a 3D printed deformable head configured to expand on an opposite side of the microcontroller or electronics board to retain the microcontroller or electronics board to the 3D printed circuit board.
